(19) **Europäisches Patentamt European Patent Office Office européen des brevets**

(11) **EP 2 695 254 B1**

(12) **EUROPEAN PATENT SPECIFICATION**

(45) Date of publication and mention of the grant of the patent:
**07.06.2023 Bulletin 2023/23**

(21) Application number: **12768068.4**

(22) Date of filing: **28.03.2012**

(51) International Patent Classification (IPC):
**B29C 35/08** (2006.01)    **B29C 35/10** (2006.01)
**B29C 71/02** (2006.01)    **F26B 3/28** (2006.01)
**F26B 13/10** (2006.01)    **H05K 3/12** (2006.01)
**H05B 41/34** (2006.01)    **H05K 1/03** (2006.01)

(52) Cooperative Patent Classification (CPC):
**B29C 35/0805; B29C 35/10; B29C 71/02; F26B 3/28; F26B 13/10; H05K 3/1283;** B29C 2071/022; H05B 41/34; H05K 1/0386; H05K 3/125; H05K 2203/1545

(86) International application number:
**PCT/US2012/030845**

(87) International publication number:
**WO 2012/138516 (11.10.2012 Gazette 2012/41)**

(54) **METHOD FOR DRYING THIN FILMS IN AN ENERGY EFFICIENT MANNER**

VERFAHREN ZUM ENERGIESPARENDEN TROCKNEN VON DÜNNFILMEN

PROCÉDÉ POUR SÉCHER DES COUCHES MINCES D'UNE MANIÈRE ÉCOÉNERGÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.04.2011 US 201113082469**

(43) Date of publication of application:
**12.02.2014 Bulletin 2014/07**

(73) Proprietor: **NCC Nano, LLC Dallas, TX 75251 (US)**

(72) Inventors:
• **SCHRODER, Kurt, A.**
**Coupland, TX 78615 (US)**
• **RAWSON, Ian M.**
**Austin, TX 78723 (US)**
• **McCOOL, Steven, C.**
**Austin, TX 78728 (US)**
• **EDD, Andrew, E.**
**Austin, TX 78727 (US)**
• **DASS, Ronald, I.**
**Austin, TX 78753 (US)**

(74) Representative: **Gill, David Alan WP Thompson 138 Fetter Lane London EC4A 1BT (GB)**

(56) References cited:
WO-A2-2006/015328    WO-A2-2006/015328
US-A- 5 194 723    US-A- 5 194 723
US-A- 5 858 819    US-A- 5 858 819
US-A1- 2006 216 927    US-A1- 2006 216 927
US-A1- 2009 181 184    US-A1- 2010 007 285
US-A1- 2010 007 285    US-A1- 2010 098 874
US-B2- 6 660 572    US-B2- 6 660 572
US-B2- 7 317 870    US-B2- 7 317 870

• **SCHWERTZ, K.: 'Useful Estimations and Rules of Thumb for Optomechanics.' THESIS, [Online] 07 May 2010, THE UNIVERSITY OF ARIZONA., XP055130969 Retrieved from the Internet: <URL:http://www.optimaxsi.com/PDFs/RulesOf T humbOptomechanics.pdf> [retrieved on 2012-07-04]**

## Description

## BACKGROUND OF THE INVENTION

### 1. Technical Field

The present invention relates to a method for drying a thin film stack having a thin film located on a substrate according to claim 1 and to a method for thermally processing a thin film stack having a thin film located on a substrate according to claim 5.

### 2. Description of Related Art

When it comes to choosing substrates for supporting thin films, it is generally more preferable to employ inexpensive substrates, such as polyethylene terephthalate (PET), polycarbonate, cellulose, etc., over expensive substrates, such as silicones, fluorocarbons, ceramic, glass, etc., due to cost reasons. However, inexpensive substrates tend to have lower maximum working temperatures than their expensive counterparts such that only relatively low temperatures can be utilized to dry thin films located on inexpensive substrates.

According to the Arrhenius equation, thermally driven processes, such as drying (i.e., driving off solvent), particle sintering, densification, chemical reaction initiation, chemical reaction modulation, phase transformation, grain growth, annealing, heat treating, etc., are related to the processing temperature in an exponential fashion. Hence, a small reduction in the drying temperature will require a significantly longer drying time and more energy, which translates to a more costly drying operation.

Consequently, it would be desirable to provide an improved process for thermally processing thin films located on inexpensive substrates without extending the processing time.

US 2010007285 describes curing apparatus for thermally processing thin films on low-temperature substrates at high speeds including a strobe head, a strobe control module and a conveyor control module. The strobe control module controls the power, duration and repetition rate of a set of pulses generated by a flash lamp on the strobe head. The conveyor control module along with the strobe control module provide real-time synchronization between the repetition rate of the set of pulses and the speed at which the substrate is being moved under the strobe head, according to the speed information.

WO 2006015328 describes a method of thermally processing a material including the steps of providing an article having a surface film disposed on a substrate, and exposing the thin film to at least one incident pulse of infrared, with a duration of no more than 10 s, comprising radiation at a power density of at least 0.1 $kW/cm^2$ emitted from a directed plasma arc to thermally process the thin film to heat the surface film to the desired temperature while allowing the substrate to remain at a lower temperature.

## SUMMARY OF THE INVENTION

According to one aspect of the invention there is provided a method for drying a thin film stack having a thin film located on a substrate, said method comprising: conveying said thin film stack past a flashlamp; and irradiating said thin film stack with a composite light pulse to remove solvent from said thin film, wherein said composite light pulse is formed by a plurality of micropulses from said flashlamp, wherein a total time duration of said composite light pulse is shorter than a total thermal equilibration time of said thin film stack, wherein said total thermal equilibrium time of said thin film stack is a combination of a thermal equilibrium time of said thin film and a thermal equilibrium time of said substrate.

According to a second aspect of the invention there is provided a method for thermally processing a thin film stack having a thin film located on a substrate, said method comprising: conveying said thin film stack past a flashlamp; and irradiating said thin film stack with a composite light pulse to thermally process said thin film, wherein said composite light pulse is formed by a plurality of micropulses from said flashlamp, wherein a total time duration of said composite light pulse is shorter than a total thermal equilibration time of said thin film stack, wherein said total thermal equilibrium time of said thin film stack is a combination of a thermal equilibrium time of said thin film and a thermal equilibrium time of said substrate.

In accordance with a preferred embodiment of the present invention, a thin film stack is thermally processed by conveying the thin film stack past a flashlamp during which the thin film stack is irradiated with a composite light pulse from the flashlamp. The composite light pulse is composed of multiple micropulses. The time duration of the composite light pulse is shorter than a total thermal equilibration time of the thin film stack, and when the thin film stack is being conveyed past the flashlamp, the thin film stack should move less than 10% of the length of the irradiating area in the conveyance direction during the delivery of the composite light pulse.

All features and advantages of the present invention will become apparent in the following detailed written description.

## BRIEF DESCRIPTION OF THE DRAWINGS

The invention itself, as well as a preferred mode of use, further objects, and advantages thereof, will best be understood by reference to the following detailed description of an illustrative embodiment when read in conjunction with the accompanying drawings, wherein:

Figure **1** is a diagram of a thin film stack;

Figure **2a** shows the intensity and pulse length of a single light pulse and a composite light pulse, each can be used for heating the thin film stack from Figure **1**;

Figure **2b** is a graph showing the temperature of a substrate versus time after the substrate has been irradiated by the single light pulse from Figure **2a**;

Figure **2c** is a graph showing the temperature of a substrate versus time after the substrate has been irradiated by the composite light pulse from Figure **2a**;

Figure **2d** is a composite light pulse capable of providing two different constant processing temperature zones;

Figure **2e** is a graph showing the temperature of a substrate versus time after the substrate has been irradiated by the composite light pulse from Figure **2d**;

Figure **3** is a diagram of a drying apparatus for generating the composite light pulse from Figure **2a**, in accordance with a preferred embodiment of the present invention; and

Figure **4** is a block diagram of a flashlamp controller within the drying apparatus from Figure **3**.

## DETAILED DESCRIPTION OF A PREFERRED EMBODIMENT

A. Thermal Equilibration Time of a Thin Film Stack

The thermal equilibrium time $\tau$ of a layer of material is calculated by:

$$\tau = \frac{c \rho x^2}{4 \kappa}$$

*where*

c = specific heat of the material
$\rho$ = mass density of the material
x = thickness of the material
$\kappa$ = thermal conductivity of the material

The total thermal equilibration time $\tau_{stack}$ for a thin film stack having multiple layers of different materials with different thicknesses can be calculated by:

$$\tau_{stack} = \left( \sqrt{\tau_1} + \sqrt{\tau_2} + \sqrt{\tau_3} \cdots \sqrt{\tau_i} \right)^2$$

*where* $\tau_1$, $\tau_2$, $\tau_3$, etc. are the thermal equilibrium time of each of the individual layers, respectively, of the thin film stack.

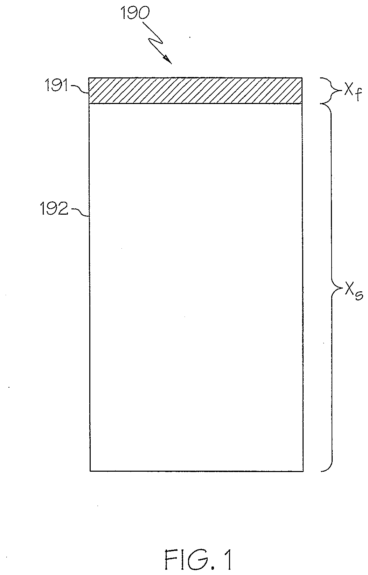

Although a thin film stack may include multiple layers of different materials, in practice, a thin film stack is usually comprised of a layer of thin film on top of a comparatively thicker substrate for supporting the thin film. In such a case, the thermal equilibration time of a thin film stack is often dominated by the substrate. For example, for a thin film stack **190** composed of a thin film **191** located on top of a substrate **192**, as shown in Figure **1**, wherein thin film **191** has a thickness $x_f$ and a thermal equilibration time $\tau_f$, and substrate **192** has a thickness $x_s$ and a thermal equilibration time $\tau_s$, the total thermal equilibration time $\tau_{stack}$ of thin film stack **190** is simply the thermal equilibration time $\tau_s$ of substrate **192** when $x_s \gg x_f$.

The above-mentioned principle can be illustrated with a practical example. When substrate **192** is made of polyethylene terephthalate (PET) with $c_s$ = 730 J/kg-K, $\rho_s$ = 1.4 g/cm$^3$, $x_s$ = 150 micron and $\kappa_s$ = 0.24 W/m-K, and thin film **191** is made of silver with $c_f$ = 235 J/kg-K, $\rho_f$ = 10.5 g/cm$^3$, $x_f$ = 1 micron and $\kappa_f$ = 420 W/m-K, the thermal equilibration time of substrate **192** ($\tau_s$) and thin film **191** ($\tau_f$) are 24 ms and $1.5 \times 10^{-6}$ ms, respectively. Thus, the thermal equilibration time of thin film stack **191** is nearly indistinguishable from that of substrate **192** alone when $x_s \gg x_f$.

B. Thermal Processing of a Thin Film Stack

When thermally processing thin film **191** on substrate **192**, entire film stack **190** can be heated to a maximum working temperature of substrate **192** to minimize the thermal processing time. Importantly, it is even possible to heat thin film **191** on substrate **192** to a temperature far beyond the maximum working temperature of substrate **192** without damaging substrate **192** when substrate **192** is heated quickly and cooled quickly.

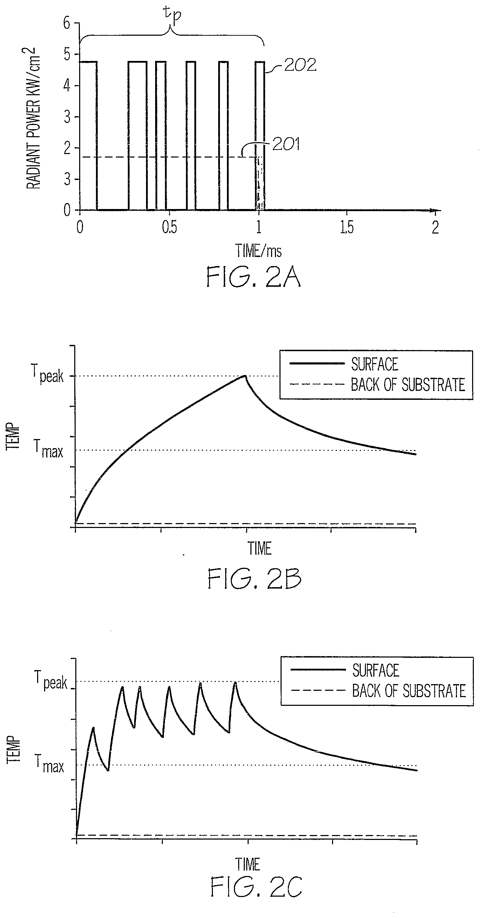

In order to achieve a very short heating time along with a very fast cooling rate for substrate **192**, a single light pulse **201** with a duration $t_p$, as depicted in Figure **2a**, can be used to heat both thin film **191** and substrate **192** to a temperature $T_{peak}$. Temperature $T_{peak}$ can be higher than the maximum working temperature $T_{max}$ of substrate **192**, as shown in Figure **2b**, because the side of substrate **192** adjacent to thin film **191** is only at temperature $T_{peak}$ for a very short time such that substrate **192** does not have an opportunity to change its properties significantly. In addition, thin film **191** is rapidly cooled via conduction to substrate **192**.

In conjunction with the physical properties and dimensions of thin film **191** and substrate **192**, both the heating time and cooling rate of thin film stack **190** are determined by the thermal profile of the light pulse (*i.e.*, the shape of the light pulse).

In accordance with a preferred embodiment of the present invention, light pulse **201** of Figure **2a** can be delivered to substrate **192** in the form of a composite light pulse **202**. Composite light pulse **202** is composed of multiple light pulses. When composite light pulse **202** having a correct thermal profile is utilized, substrate **192** can be heated to a temperature far beyond its maximum working temperature in order to achieve the shortest drying time. When drying thin film stack **190,** the pulse length of composite light pulse **202** is preferably shorter than the thermal equilibration time $\tau_{stack}$ of thin film stack **190.**

As shown in Figure **2a,** composite light pulse **202** includes multiple micropulses to allow the temperature profile in a thin film stack, such as thin film stack **190** from Figure **1,** to be customized for an optimal cure. In its simplest form, composite light pulse **202** includes uniform micropulses. In this case, composite light pulse **202** can be shaped by six different parameters: i. intensity (voltage), ii. composite pulse length, iii. average number of composite pulses that impinge on a substrate in any given area on a thin film stack, iv. pulse repetition frequency, v. number of micropulses, and vi. duty cycle of micropulses. When the non-uniform micropulses are utilized, the pulse length and delay of each individual micropulse can be specified.

With substrate **192** having a maximum working temperature $T_{max}$, thin film **191** located on substrate **192** can be heated by composite light pulse **202** from Figure **2a** to a temperature $T_{peak}$ when the heating time is very short and the cooling rate is very fast. As shown in Figure **2c,** when the temperature at the surface of substrate **192** briefly reaches $T_{peak}$, and the temperature at the surface of substrate **192** quickly levels to less than the maximum working temperature $T_{max}$. Also, substrate **192** quickly reaches the thermal equilibrium after being heated by the composite light pulse.

The parameters of an optimal composite light pulse for processing of a thin film can be determined experimentally. First, a damage threshold on a thin film stack from a single light pulse is ascertained by selecting a pulse length that is shorter than the thermal equilibration time of the thin film stack and exposing the thin film stack to a series of single light pulses of increasing areal power density until some damage to the thin film stack is observed. The optimal thermal processing for that single light pulse length is generally the power that is slightly less than the damage threshold power. Since the damage mechanism is often thermally driven, *i.e.,* related to the amount of energy deposited, a shorter pulse length generally has a higher areal power density threshold. Additionally, when the thin film is absorbing the light, shorter pulse lengths generally preferentially heat the thin film over the substrate that increases the energy efficiency of the process. However, in the case of a drying process or any thermal process that generates gas, the damage threshold is also related to the rate at which the gas can escape without causing a local "explosion" in the thin film stack. Thus, there is also fundamentally a maximum areal power density independent of pulse length, which means efficient thermal processing cannot be achieve by simply continuing to reduce the pulse length.

When the above-mentioned single light pulse is transformed into a burst of shorter pulses (*i.e.,* micropulses) of the same total pulse length, the energy efficiency of a very short pulse can be realized while depositing adequate energy to process the thin film. This processing can be done at an instantaneous power (*e.g.*, the power during a micropulse) beyond the single pulse damage threshold without damaging the thin film stack.

The optimization of a composite light pulse for thermal processing can be further improved by using a software simulation, such as SimPulse™ from NovaCentrix of Austin, Texas, to simulate the thermal response of the thin film stack due to the exposure from the composite light pulse. By inputting the thermo-physical properties of each layer in the thin film stack as well as the output from the flashlamp, the simulation software can provide the temperature at every location within the thin film stack during and after exposure to the composite pulse. When this is done, damage to the thin film stack can reveal physical mechanisms which cause damage. This allows one to design an optimal composite pulse to avoid a particular damage mechanism. For example, when the damage mechanism is a temperature limitation within the thin film stack, such as the gasification temperature of the substrate, one may process the thin film near, but not exceeding that particular temperature. Similarly, when drying a film which has multiple solvents, each solvent may boil at a particular temperature. Thus, optimal processing of that thin film may include a composite pulse with multiple constant temperature processing zones in which drying is first performed at a lower constant temperature to evaporate the more volatile solvent followed by processing at a higher constant temperature to evaporate the less volatile solvent.

Although a thin film can be processed at a significantly higher temperature than the maximum working temperature of the substrate for processing times shorter than the thermal equilibration time of the thin film stack, the temperature that the thin film stack attains after thermal equilibrium still needs to be lower than the maximum working temperature of the substrate or there will be damage. Thus, the total amount of energy that can be placed into the thin film stack cannot exceed the total energy needed to heat the thin film stack up to the maximum working temperature of the substrate. That number can be determined by calculating the total enthalpy of the thin film stack including any heat of vaporization of any solvent in the thin film.

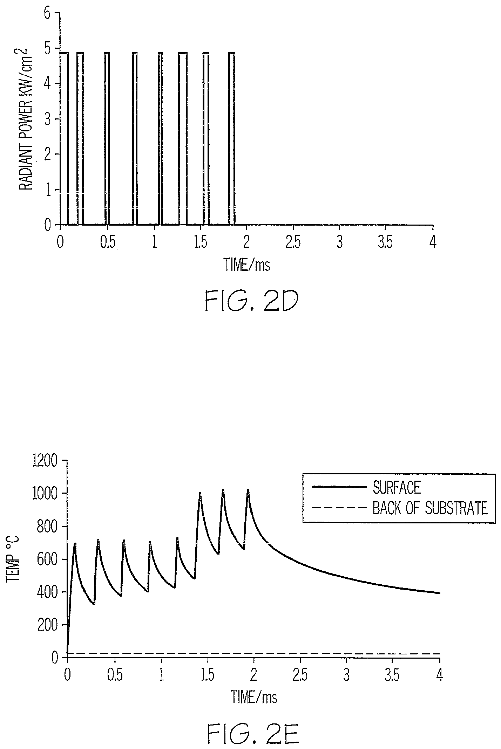

A composite light pulse can also provide two different constant processing temperature zones on a thin film stack. For example, as shown in Figure **2d,** a composite light pulse includes multiple micropulses capable of providing two different processing temperature zones, and the timing (in $\mu$s) of the composite light pulse is listed in Table I.

Table I

| Turn on | Turn off |
|---------|----------|
| 0 | 87 |
| 193 | 238 |
| 473 | 508 |
| 763 | 793 |
| 1,063 | 1,093 |
| 1,276 | 1,341 |
| 1,536 | 1,581 |
| 1,816 | 1,856 |

Figure **2e** shows the temperature of a substrate versus time after the substrate has been irradiated by the composite light pulse from Figure **2d.**

C. Apparatus for Drying a Thin Film on a Thin Film Stack

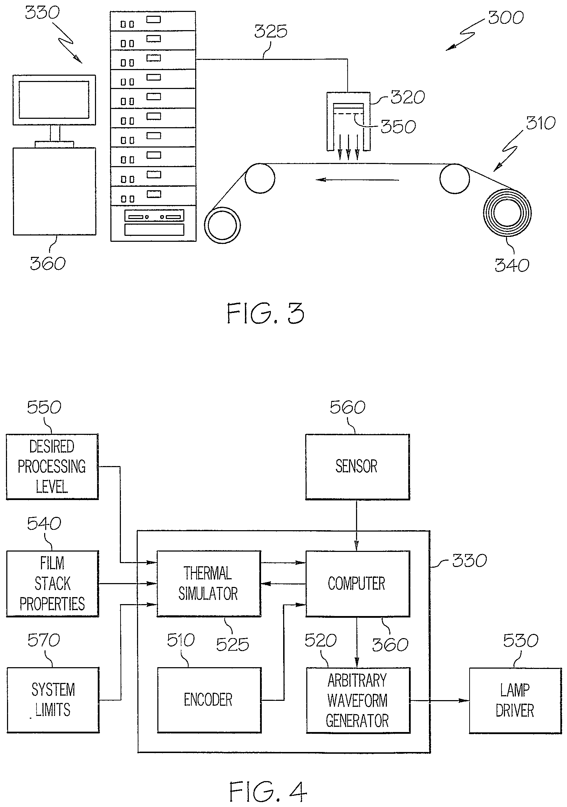

Referring now to Figure **3,** there is depicted a diagram of an apparatus for drying thin films, in accordance with a preferred embodiment of the present invention. As shown, a drying apparatus **300** includes a conveyance system **310,** a flashlamp controller **330** and a flashlamp head **320** having a flashlamp **350.** A low inductance cable **325** is connected between flashlamp controller **330** and flashlamp head **320.** Conveyance system **310** moves a thin film stack **340** past flashlamp head **320** while flashlamp controller **330** provides shaped pulses of current to flashlamp **350** using pulse width modulation (PWM) such that the shaped pulses are synchronized to the conveyance speed of thin film stack **340** on conveyance system **310.** Preferably, flashlamp **350** is a sealed flash lamp filled with gases such as xenon, krypton or argon. Flashlamp **350** can also be a water-wall flashlamp, sometimes referred to as a Directed Plasma Arc (DPA) lamp.

Flashlamp controller **330** includes a control computer **360.** Control computer **360** preferably includes a processing unit, input devices such as a keyboard, a mouse, a touchscreen, etc., and output devices such as a monitor, as they are well-known to those skilled in the art.

In order to pulse-width modulate a pulse train of a given duration, each individual pulse need to be relatively short in order to provide pulse shaping. Furthermore, the pulses need to be more intense than a source providing a single pulse since it is not turned on for a portion of the time. Thus, drying apparatus **300** needs to be capable of providing pulse lengths as short as 10 microseconds with peak power in excess of 100 kW/cm$^2$. In addition, the PWM frequency for pulses can be as fast as 50 kHz.

The shape of light pulses emitted from flashlamp **350** as well as the physical properties and dimensions of a thin film and substrate can affect the thermal gradient and the subsequent temperature at which the thin film can be dried while without damaging the substrate. Thus, drying apparatus **300** also includes multiple sensors (not shown) for collecting various information from different parts of drying apparatus **300** as well as the film and substrate on thin film stack **340.** The collected information from various sensors and user inputs are fed back into computer control system **360** in which thermal profiles can be re-calculated. Using the re-calculated thermal profiles, flashlamp controller **330** controls the waveforms of the light being delivered to thin film stack **340** by flashlamp **350** while thin film stack **340** is being conveyed under flashlamp **350.**

With reference now to Figure **4,** there is depicted a block diagram of flashlamp controller **330.** As shown, flashlamp controller **330** includes an encoder **510,** an arbitrary waveform generator **520,** a thermal simulator **525,** and control computer **360.** A user initially inputs thin film stack properties **540** and desired processing level **550** into flashlamp controller **330.** After receiving inputs, such as conveyance speed, from conveyance system **310** (from Figure **3**) and additional system limits **570,** encoder **510** provides trigger signals to computer that sends signals to arbitrary waveform generator **520** at appropriate times for curing thin films located on conveyance system **310.** With the trigger signals, arbitrary waveform generator **520** is able to generate waveforms of various shapes and timing based on user inputs **540** and **550.** Arbitrary waveform generator **520** sends waveform signals to flashlamp driver **530** that amplifies the waveform signals for driving flashlamp **350** (from Figure **3**).

The feedback information allows for continuous and real-time adjustability of parameters, such as pulse energy, pulse duration, pulse waveform, etc., when drying apparatus **300.** All of the above-mentioned parameters can be altered under software and/or hardware control on a millisecond time frame with a resolution of 0.1%.

When thin film stack **340** is moving, and the flashlamp pulse frequency is synchronized to the conveyance speed, the frequency is given by:

$$f = \frac{1.67 \times S \times O}{W}$$

*where*

f = flashlamp composite pulse rate [Hz]

S = conveyance speed [m/min]

O = overlap factor (*i.e.*, the average number of composite pulses received by substrate at any given point)

W = width of flashlamp **350** in the conveyance direction [cm]

For example, with a conveyance speed of 100 m/min, an overlap factor of 4, and a curing head width of 7 cm, the pulse rate of the strobe is 95.4 Hz. For faster conveyance speeds, this relationship can be satisfied by increasing the width of flashlamp **450** or adding additional flashlamps.

In order to achieve a uniform cure over a substrate area larger than the area irradiated by flashlamp **350,** flashlamp **350** is required to synchronize the delivery of composite light pulses to the conveyance of the substrate. However, if the conveyance speed is so fast that the substrate moves significantly during the delivery of the composite light pulse, then a uniform cure on the substrate is not possible.

In accordance with a preferred embodiment of the present invention, a uniform cure on a moving substrate can be attained over an arbitrarily long distance of thin film stack **340** if thin film stack **340** moves less than 10% of the width of flashlamp **350** in the conveyance direction during the delivery of the composite light pulse. Expressed in equation form:

$$t < 60 \times W/S$$

*where*

t = length of the composite pulse [ms]
W = width of flashlamp **350** in the conveyance direction [cm]
S = conveyance speed [m/min]

Table II shows maximum pulse length of composite pulse [ms] for uniform curing versus conveyance speed and the width of light pulses in the conveyance direction. The time in milliseconds that composite pulse must be shorter than to attain uniform processing in the conveyance direction.

Table II

| speed [m/min] | light pulse width | | |
|---|---|---|---|
| | 7 cm | 14 cm | 28 cm |
| 1 | 420 | 840 | 1,680 |
| 10 | 42 | 84 | 168 |
| 100 | 4.2 | 8.4 | 16.8 |
| 1,000 | 0.42 | 0.84 | 1.68 |

Example 1: Drying and sintering of nano-silver ink on PET

Two samples of nano-silver ink on PET were prepared, each sample being a 1 micron thick of nano-silver thin film printed on a 150 micron thick PET substrate. A first sample was dried in an oven at 150 °C for 5 minutes to drive off solvent and exposed to a single light pulse of 1 ms in duration at 1.6 kW/cm$^2$ at a web-

speed of 10 m/min with an overlap factor of 4 depositing 1.6 J/cm$^2$ of energy with each delivery of single light pulse for a total of 6.4 J/cm$^2$ energy deposited onto the substrate to sinter the silver.

Without being dried in the oven, the second sample was exposed to a 1 ms long composite light pulse comprised of 6 different micropulses of differing pulse lengths and delays, and the timing (in $\mu$s) of the composite light pulse is shown in Table III.

Table III

| Turn on | Turn off |
|---|---|
| 0 | 100 |
| 289 | 374 |
| 439 | 474 |
| 604 | 644 |
| 789 | 829 |
| 999 | 1,037 |

The intensity of the light pulses was increased to 4.7 kW/cm$^2$ so that the total amount of energy deposited was identical to the first sample. The material was processed at a webspeed of 10 m/min with a overlap factor of 4 depositing 1.6 J/cm$^2$ with each light pulse for a total of 6.4 × 1.6 J/cm$^2$ deposited onto the substrate to dry and sinter the silver in a single pass.

The implication of this type of processing is that more processing can be done with less total energy than a conventional oven. In the case of conventional oven processing, the entire substrate, the air around it, and the conventional oven surrounding the processing zone must be heated to process the thin film.

The thermal response at the thin film as well as the back of the substrate for a single pulse neglecting the enthalpy absorbed by the evaporation of solvents is similar to the curve shown in Figure **2b.** The thermal response from the composite light pulse at the thin film and at the back of the substrate is similar to the curve shown in Figure **2c.** A comparison of the curves from Figures **2b** and **2c** shows that the amount of time the thin film is at an elevated temperature is significantly more from a composite light pulse from a single light pulse. Specifically, the amount of time the thin film spends at about 800 °C (*see* Figure **2c**) is approximately twice as much as that from a single light pulse (*see* Figure **2b**). As both cases use the same amount of radiant exposure, this translates into more thermal processing for the same amount of energy deposited. In sum, the same amount of thermal processing can be achieved with less energy.

Note that this has a very different effect than a continuous train of small, rapid light pulses. In that case, the timescale of heating would be larger than the thermal equilibration timescale of the thin film stack and would be similar to being heated by a conventional oven. Thus, the surface would not reach the peak temperatures achieved in the present invention without damaging the thin film stack. Consequently, it would have a lower processing rate over the present invention.

Additionally, the composite light pulse has another significant advantage in thermal processes that evolve gas such has drying or gas-evolving chemical reactions. Since the composite light pulse includes multiple micropulses, the thin film being dried is allowed to "breathe," *i.e.,* release gas, between micropulses. This action prevents the build up of gas in the thin film that would otherwise undergo a cohesive failure due to the rapidly expanding gas.

Example 2: Multi-Temperature Zone Processing Accounting for Solvent Evaporation

The tunability of the pulse profile is particularly useful for drying thin films where multiple distinct processes can be performed in a single pass. In short, a thin film that contains solvent cannot be heated as rapidly as one which is already dried. That is, when solvent is in the thin film, a high power will rapidly expand the solvent and "explode" the thin film, resulting in a cohesive failure. Ideally, one desires to first remove the solvent at a lower power until it is removed followed by a higher power exposure to perform additional thermal processing such as sintering. Figure **2d** shows a representative thermal response profile of the film and substrate of example 1 from a composite pulse in which the first portion of the pulse maintains the temperature at the surface of the thin film at about 700 °C for the first 1.2 ms, followed by a higher power exposure in order to maintain the thin film's temperature at 1,000 °C for the remaining 0.5 ms. In this example, the solvent evaporation occurs during the lower power processing zone and the sintering occurs during the higher temperature processing zone. Thus, as opposed to ordinary zone processing in which a material is conveyed in a oven with different regions, or zones, with different temperatures. The present invention allows the same type of processing to be done in time and is thus termed "temporal zone processing."

The same principle can be applied to a thin film containing multiple solvents in which multiple heating zones can be formed to evaporate each solvent in order of decreasing volatility. In the system of Example 1, the pulse profile can be calculated by accounting for the total enthalpy change of the primary solvent components, silver ink pigment and substrate when exposed to 6.4 J/cm$^2$, assuming that the system is perfectly absorptive and no energy is lost to the surrounding environment, it is found that 4.4 J/cm$^2$ is required just to heat and evaporate the solvents. The remaining silver metal heats very quick to approximately 1,000 °C requiring a total enthalpy change of 0.15 J/cm$^2$. During the time between the pulses the energy leaks into the substrate causing it to rise to an estimate 146 °C requiring and enthalpy change of 1.85 J/cm$^2$. The total amount of energy required is approximately 6.4 J/cm$^2$.

Example 3: Prevention of Cohesive Failure in a Thin Film by Modulation of Gas Generation

An aqueous copper precursor ink was formulated comprising 10.0% wt. copper (II) oxide, 4.5% wt. copper (II) acetate in a base containing ethylene glycol and glycerol. Traces were printed onto a 125 micron thick PET sheet using an Epson Stylus C88 ink jet printer. Upon curing with a flashlamp, the copper oxide and copper acetate are reduced by the ethylene glycol and glycerol to form a film of conductive copper metal. The reduction reaction generates a moderate amount of gas.

The printed film was cured using the method and apparatus of the present invention with the following conditions: voltage 250 V, composite light pulse duration = 1,050 microseconds, 4 micropulses with a duty cycle of 0.6 (*i.e.*, each micropulse was 175 microsecond long with a delay of 117 $\mu$s between pulses), overlap factor = 3, web speed = 6.4 m/min. The sample yield was 100% with an average sheet resistance of 3.7 $\Omega/\square$.

When the identical trace was cured with the same equipment, but with only a single pulse, the gas evolution caused a cohesive failure of the traces resulting in a sample yield of only 64%. The average sheet resistance was 5.2 $\Omega/\square$. Changing any of the input variables resulted in a less conductive or poorer yield trace.

As has been described, the present invention provides a method for thermally processing a thin film on a moving substrate. The present invention allows the thin film to be at an elevated temperature for a significantly longer period of time than the prior art. This is done using the same amount of radiant energy in the same amount of total time so no damage occurs to the substrate.

**Claims**

1. A method for drying a thin film stack (190) having a thin film (191) located on a substrate (192), said method comprising:

   conveying said thin film stack (190) past a flashlamp (350); and
   irradiating said thin film stack (190) with a composite light pulse (202) to remove solvent from said thin film (191), wherein said composite light pulse (202) is formed by a plurality of micropulses from said flashlamp (350), **characterized in that** a total time duration of said composite light pulse is shorter than a total thermal equilibration time of said thin film stack, wherein the thermal equilibrium time of a layer of material is calculated by

$$\tau_m = \frac{c\rho x^2}{4\kappa}$$

where c is the specific heat of the material, $\rho$ is the mass density of the material, x is the thickness of the material and $\kappa$ is the thermal conductivity of the material, and
wherein said total thermal equilibrium time of said thin film stack (190) is

$$\tau = \left(\sqrt{\tau_1} + \sqrt{\tau_2}\right)^2$$

wherein $\tau_1$ and $\tau_2$ are thermal equilibrium time of said thin film (191) and substrate (192) respectively.

2. The method of Claim 1, wherein an instantaneous areal power density of said composite light pulse (202) is greater than the single pulse damage threshold of the same pulse length.

3. The method of Claim 1, wherein a constant temperature is maintained at a location within said thin film stack (190) during processing.

4. The method of Claim 1, wherein the total energy deposited into said thin film stack (190) is less than the amount of energy required to heat said thin film stack (190) up to a maximum working temperature of said substrate (192).

5. A method for thermally processing a thin film stack (190) having a thin film (191) located on a substrate (192), said method comprising:

   conveying said thin film stack (190) past a flashlamp (350); and
   irradiating said thin film stack (190) with a composite light pulse (202) to thermally process said thin film (191), wherein said composite light pulse (202) is formed by a plurality of micropulses from said flashlamp (350), **characterized in that** a total time duration of said composite light pulse (202) is shorter than a total thermal equilibration time of said thin film stack (190), wherein the thermal equilibrium time of a layer of material is calculated by

$$\tau_m = \frac{c\rho x^2}{4\kappa}$$

where c is the specific heat of the material, $\rho$ is the mass density of the material, x is the thickness of the material and $\kappa$ is the thermal conductivity of the material, and wherein said total thermal equilibrium time of said thin film stack (190) is

$$\tau = \left(\sqrt{\tau_1} + \sqrt{\tau_2}\right)^2$$

wherein $\tau_1$ and $\tau_2$ are thermal equilibrium time of said thin film (191) and substrate (192) respectively.

6. The method of Claim 1 or 5, wherein said conveying further includes conveying said thin film stack less than 10% of the length of a irradiating area of said flashlamp in the conveyance direction during the time said composite light pulse is being delivered.

7. The method of Claim 1 or 5, wherein said total thermal equilibration time of said thin film stack (190) is approximately the same as thermal equilibration time of said substrate (192).

8. The method of Claim 1 or 5, wherein said micropulses have identical timings.

9. The method of Claim 1 or 5, wherein said micropulses have different timings.

10. The method of Claim 1 or 5, wherein said micropulses are shaped by voltage, pulse length, average number of micropulses that impinge on said substrate (192) in any given area, pulse repetition frequency, number of micropulses, and duty cycle.

11. The method of Claim 1 or 5, wherein said substrate (192) has a maximum working temperature of less than 450°C.

12. The method of Claim 5, wherein an instantaneous areal power density of said composite light pulse (202) is greater than the single pulse damage threshold of the same pulse length.

13. The method of Claim 5, wherein a constant temperature is maintained at a location within said thin film stack (190) during processing.

14. The method of Claim 5, wherein the total energy deposited into said thin film stack (190) is less than the amount of energy required to heat said thin film stack (190) up to a maximum working temperature of said substrate (192).

**Patentansprüche**

1. Verfahren zum Trocknen eines Dünnfilmstapels (190), bei dem ein Dünnfilm (191) auf einem Substrat (192) angeordnet ist, wobei das Verfahren Folgendes umfasst:

Transportieren des Dünnfilmstapels (190) an einer Blitzlampe (350) vorbei und Bestrahlen des Dünnfilmstapels (190) mit einem zusammengesetzten Lichtimpuls (202) zwecks Entfernens von Lösungsmittel aus dem Dünnfilm (191), wobei der zusammengesetzte Lichtimpuls (202) von mehreren Mikroimpulsen aus der Blitzlampe (350) gebildet wird,

**dadurch gekennzeichnet, dass** eine Gesamtdauer des zusammengesetzten Lichtimpulses geringer ist als eine Gesamttemperaturausgleichszeit des Dünnfilmstapels, wobei die Temperaturausgleichszeit einer Materialschicht mithilfe folgender Gleichung berechnet wird:

$$\tau_m = \frac{c\rho x^2}{4\kappa} \quad ,$$

in der c die spezifische Wärme des Materials, $\rho$ die Massendichte des Materials, x die Dicke des Materials und $\kappa$ die Wärmeleitfähigkeit des Materials ist, und
wobei die Gesamttemperaturausgleichszeit des Dünnfilmstapels (190)

$$\tau = \left(\sqrt{\tau_1} + \sqrt{\tau_2}\right)^2$$

ist, wobei $\tau_1$ und $\tau_2$ die Temperaturausgleichszeit des Dünnfilms (191) beziehungsweise des Substrats (192) ist.

2. Verfahren nach Anspruch 1, wobei eine momentane Flächenleistungsdichte des zusammengesetzten Lichtimpulses (202) höher ist als die Einzelimpulszerstörschwelle von gleicher Impulslänge.

3. Verfahren nach Anspruch 1, wobei an einer Stelle in dem Dünnfilmstapel (190) bei der Weiterverarbeitung eine konstante Temperatur beibehalten wird.

4. Verfahren nach Anspruch 1, wobei die in den Dünnfilmstapel (190) eingebrachte Gesamtenergie geringer ist als der Energiebetrag, der zum Erwärmen des Dünnfilmstapels (190) bis auf eine maximale Arbeitstemperatur des Substrats (192) benötigt wird.

5. Verfahren zum thermischen Weiterverarbeiten eines Dünnfilmstapels (190), bei dem ein Dünnfilm (191) auf einem Substrat (192) angeordnet ist, wobei das Verfahren Folgendes umfasst:

Transportieren des Dünnfilmstapels (190) an einer Blitzlampe (350) vorbei und Bestrahlen des Dünnfilmstapels (190) mit einem zusammengesetzten Lichtimpuls (202) zwecks thermischer Weiterverarbeitung des Dünnfilms (191), wobei der zusammengesetzte Lichtimpuls (202) von mehreren Mikroimpulsen aus der Blitzlampe (350) gebildet wird,

**dadurch gekennzeichnet, dass** eine Gesamtdauer des zusammengesetzten Lichtimpulses (202) geringer ist als eine Gesamttemperaturausgleichszeit des Dünnfilmstapels (190), wobei die Temperaturausgleichszeit einer Materialschicht mithilfe folgender Gleichung berechnet wird:

$$\tau_m = \frac{c\rho x^2}{4\kappa} \quad ,$$

in der c die spezifische Wärme des Materials, $\rho$ die Massendichte des Materials, x die Dicke des Materials und $\kappa$ die Wärmeleitfähigkeit des Materials ist, und
wobei die Gesamttemperaturausgleichszeit des Dünnfilmstapels (190)

$$\tau = \left(\sqrt{\tau_1} + \sqrt{\tau_2}\right)^2$$

ist, wobei $\tau_1$ und $\tau_2$ die Temperaturausgleichszeit des Dünnfilms (191) beziehungsweise des Substrats (192) ist.

6. Verfahren nach Anspruch 1 oder 5, wobei das Transportieren ferner das Transportieren des Dünnfilmstapels in Transportrichtung um weniger als 10% der Länge eines Bestrahlungsbereichs der Blitzlampe in dem Zeitraum umfasst, in dem der zusammengesetzte Lichtimpuls abgegeben wird.

7. Verfahren nach Anspruch 1 oder 5, wobei die Gesamttemperaturausgleichszeit des Dünnfilmstapels (190) in etwa der Temperaturausgleichszeit des Substrats (192) entspricht.

8. Verfahren nach Anspruch 1 oder 5, wobei die Mikroimpulse den gleichen Takt haben.

9. Verfahren nach Anspruch 1 oder 5, wobei die Mikroimpulse einen unterschiedlichen Takt haben.

10. Verfahren nach Anspruch 1 oder 5, wobei die Mikroimpulse durch Spannung, Impulslänge, durchschnittliche Anzahl Mikroimpulse, die in einem bestimmten Bereich auf dem Substrat (192) auftreffen, Impulsfolgefrequenz, Anzahl Mikroimpulse und Einschaltdauer geformt werden.

**11.** Verfahren nach Anspruch 1 oder 5, wobei das Substrat (192) eine maximale Arbeitstemperatur von weniger als 450°C hat.

**12.** Verfahren nach Anspruch 5, wobei eine momentane Flächenleistungsdichte des zusammengesetzten Lichtimpulses (202) höher ist als die Einzelimpulszerstörschwelle von gleicher Impulslänge.

**13.** Verfahren nach Anspruch 5, wobei an einer Stelle in dem Dünnfilmstapel (190) bei der Weiterverarbeitung eine konstante Temperatur beibehalten wird.

**14.** Verfahren nach Anspruch 5, wobei die in den Dünnfilmstapel (190) eingebrachte Gesamtenergie geringer ist als der Energiebetrag, der zum Erwärmen des Dünnfilmstapels (190) bis auf eine maximale Arbeitstemperatur des Substrats (192) benötigt wird.

**Revendications**

**1.** Procédé pour sécher un empilement de couches minces (190) présentant une couche mince (191) située sur un substrat (192), ledit procédé comprenant :

un acheminement dudit empilement de couches minces (190) devant une lampe flash (350) ; et une irradiation dudit empilement de couches minces (190) avec une impulsion lumineuse composite (202) pour éliminer un solvant de ladite couche mince (191), dans lequel ladite impulsion lumineuse composite (202) est formée par une pluralité de micro-impulsions provenant de ladite lampe flash (350), **caractérisé en ce qu'**une durée totale de ladite impulsion lumineuse composite est plus courte qu'un temps d'équilibre thermique total dudit empilement de couches minces, dans lequel le temps d'équilibre thermique d'une couche de matériau est calculé par

$$\tau_m = \frac{c\rho x^2}{4\kappa}$$

dans laquelle c est la chaleur spécifique du matériau, $\rho$ est la masse volumique du matériau, x est l'épaisseur du matériau et $\kappa$ est la conductivité thermique du matériau, et
dans lequel ledit temps d'équilibre thermique total dudit empilement de couches minces (190) est

$$\tau = \left(\sqrt{\tau_1} + \sqrt{\tau_2}\right)^2$$

dans laquelle $\tau_1$ et $\tau_2$ sont un temps d'équilibre thermique de ladite couche mince (191) et dudit substrat (192) respectivement.

**2.** Procédé selon la revendication 1, dans lequel une densité surfacique de puissance instantanée de ladite impulsion lumineuse composite (202) est supérieure au seuil d'endommagement d'impulsion unique de la même longueur d'impulsion.

**3.** Procédé selon la revendication 1, dans lequel une température constante est maintenue à un emplacement à l'intérieur dudit empilement de couches minces (190) durant un traitement.

**4.** Procédé selon la revendication 1, dans lequel l'énergie totale déposée dans ledit empilement de couches minces (190) est inférieure à la quantité d'énergie requise pour chauffer ledit empilement de couches minces (190) jusqu'à une température de travail maximum dudit substrat (192).

**5.** Procédé pour traiter thermiquement un empilement de couches minces (190) présentant une couche mince (191) située sur un substrat (192), ledit procédé comprenant :

un acheminement dudit empilement de couches minces (190) devant une lampe flash (350) ; et une irradiation dudit empilement de couches minces (190) avec une impulsion lumineuse composite (202) pour traiter thermiquement ladite couche mince (191), dans lequel ladite impulsion lumineuse composite (202) est formée par une pluralité de micro-impulsions provenant de ladite lampe flash (350), **caractérisé en ce qu'**une durée totale de ladite impulsion lumineuse composite (202) est plus courte qu'un temps d'équilibre thermique total dudit empilement de couches minces (190), dans lequel le temps d'équilibre thermique d'une couche de matériau est calculé par

$$\tau_m = \frac{c\rho x^2}{4\kappa}$$

dans laquelle c est la chaleur spécifique du matériau, $\rho$ est la masse volumique du matériau, x est l'épaisseur du matériau et $\kappa$ est la conductivité thermique du matériau, et
dans lequel ledit temps d'équilibre thermique total dudit empilement de couches minces (190) est

$$\tau = \left(\sqrt{\tau_1} + \sqrt{\tau_2}\right)^2$$

dans laquelle $\tau_1$ et $\tau_2$ sont un temps d'équilibre thermique de ladite couche mince (191) et dudit substrat (192) respectivement.

6. Procédé selon la revendication 1 ou 5, dans lequel ledit acheminement inclut en outre un acheminement dudit empilement de couches minces à moins de 10 % de la longueur d'une zone d'irradiation de ladite lampe flash dans la direction d'acheminement durant le temps que ladite impulsion lumineuse composite est délivrée.

7. Procédé selon la revendication 1 ou 5, dans lequel ledit temps d'équilibre thermique total dudit empilement de couches minces (190) est approximativement le même qu'un temps d'équilibre thermique dudit substrat (192).

8. Procédé selon la revendication 1 ou 5, dans lequel lesdites micro-impulsions présentent des temporisations identiques.

9. Procédé selon la revendication 1 ou 5, dans lequel lesdites micro-impulsions présentent des temporisations différentes.

10. Procédé selon la revendication 1 ou 5, dans lequel lesdites micro-impulsions sont formées par une tension, une longueur d'impulsion, un nombre moyen de micro-impulsions qui agit sur ledit substrat (192) dans n'importe quelle zone, fréquence de répétition d'impulsion, n'importe quel nombre de micro-impulsions, et cycle d'utilisation donnés.

11. Procédé selon la revendication 1 ou 5, dans lequel ledit substrat (192) présente une température de travail maximum inférieure à 450 °C.

12. Procédé selon la revendication 5, dans lequel une densité surfacique de puissance instantanée de ladite impulsion lumineuse composite (202) est supérieure au seuil d'endommagement d'impulsion unique de la même longueur d'impulsion.

13. Procédé selon la revendication 5, dans lequel une température constante est maintenue à un emplacement à l'intérieur dudit empilement de couches minces (190) durant un traitement.

14. Procédé selon la revendication 5, dans lequel l'énergie totale déposée dans ledit empilement de couches minces (190) est inférieure à la quantité d'énergie requise pour chauffer ledit empilement de couches minces (190) jusqu'à une température de travail maximum dudit substrat (192).

FIG. 1

FIG. 2A

FIG. 2B

FIG. 2C

FIG. 2D

FIG. 2E

330

325

300

320
350

310

340

360

FIG. 3

550
DESIRED
PROCESSING
LEVEL

560
SENSOR

540
FILM
STACK
PROPERTIES

THERMAL
SIMULATOR

COMPUTER

330

570
SYSTEM
LIMITS

510

525

520

360

530

ENCODER

ARBITRARY
WAVEFORM
GENERATOR

LAMP
DRIVER

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010007285 A

- WO 2006015328 A